# EUROPÄISCHE PATENTSCHRIFT

(11) **EP 1 752 642 B1**
(45) Veröffentlichungstag und Bekanntmachung des Hinweises auf die Patenterteilung: **21.11.2007**
(21) Anmeldenummer: 05016981.2
(22) Anmeldetag: 04.08.2005
(51) Int. Cl.: F02D 41/20

(54) **Verfahren und Vorrichtung zum Überwachen und Beurteilen der Funktion eines piezoelektrischen Aktors**
Method and apparatus for checking and diagnosing a piezo electrical actuator
Procédé et dispositif de surveillance et diagnostic d'un actionneur piézoélectrique

(43) Veröffentlichungstag der Anmeldung: 14.02.2007
(73) Patentinhaber: Delphi Technologies, Inc., Troy, MI 48007 (US)
(72) Erfinder: Sciortino, Giacomo G., 49076 Osnabrück (DE); Goat, Christopher A., Offham Kent ME 19 5NU (GB)
(74) Vertreter: Manitz, Finsterwald & Partner GbR

(56) Entgegenhaltungen:
- EP-A- 1 139 445
- EP-A- 1 167 729
- EP-A- 1 450 028
- DE-A1- 10 008 752
- DE-C1- 19 612 179
- US-B1- 6 487 505

## Beschreibung

Die Erfindung betrifft ein Verfahren und eine Vorrichtung zum Überwachen und Beurteilen der Funktion eines piezoelektrischen Aktors.

Piezoelektrische Aktoren sind grundsätzlich bekannt und finden beispielsweise in piezoelektrisch betätigten Kraftstoffeinspritzventilen, so genannten Piezo-Injektoren, Verwendung, um die Zufuhr von Kraftstoff in die Verbrennungskammer eines Verbrennungsmotors, z.B. eines Kraftfahrzeugs, zu steuern.

Ein bekannter piezoelektrischer Aktor umfasst ein Paket von typischerweise mehreren hundert übereinander gestapelten und piezoelektrische Eigenschaften aufweisenden Keramikschichten. Jede einzelne Keramikschicht kann durch Aufbringen einer entsprechenden elektrischen Ladung um einige Zehntel Mikrometer ausgedehnt werden, wodurch sich das gesamte Piezopaket je nach Anzahl der übereinander gestapelten Keramikschichten um mehrere Hundertstel Millimeter ausdehnt. Dies kann ausreichend sein, um eine Ventilnadel eines Piezo-Injektors von ihrem Ventilsitz abzuheben und das Ventil zu öffnen.

Als problematisch hat sich bislang die Untersuchung von beschädigten piezoelektrischen Aktoren erwiesen, da defekte piezoelektrische Aktoren erst bei einem endgültigen Versagen als defekt erkannt werden konnten.

Oft resultiert das endgültige Versagen des piezoelektrischen Aktors aus einer übermäßigen lokalen Hitzeentwicklung, insbesondere an derjenigen Stelle, an welcher der Defekt seinen Ursprung hat. Aufgrund der lokalen Hitzeentwicklung können die zu der Fehlerstelle benachbarten Keramikschichten aufgeschmolzen bzw. an der Oberfläche der Keramikschichten angeordnete Passivierungsschichten und/oder eine Ummantelung des Piezopakets verkohlt werden, wodurch die ursprüngliche Fehlerstelle total zerstört wird.

Auf diese Weise werden nicht nur Informationen über den Grund des Versagens des piezoelektrischen Aktors, d.h. über den ursprünglichen Defekt, sondern auch Details über die zeitliche Entwicklung der Schädigung vernichtet. Ein durch Hitzeentwicklung beschädigter piezoelektrischer Aktor kann sogar so stark zerstört sein, dass nicht einmal mehr feststellbar ist, ob der Defekt des Aktors an dessen Oberfläche oder in dessen Innerem ausgelöst wurde.

Aus der US-B-6 487 505 ist ein Verfahren zur Diagnose eines piezomechanischen Systems bekannt. Das System umfasst ein mechanisches Teilsystem und ein piezoelektrisches Teilsystem, nämlich ein mit dem mechanischen Teilsystem gekoppeltes Piezoelement, welches zur Aktivierung des mechanischen Teilsystems dient. Durch die Messung und Bewertung elektrischer Kennwerte des Piezoelements wird der Funktionszustand des Gesamtsystems ermittelt und überwacht. Zu diesem Zweck wird zur Aktivierung des mechanischen Teilsystems ein Anregungssignal, z.B. ein elektrisches Rechtecksignal, an das Piezoelement angelegt. Gleichzeitig wird an dem Piezoelement ein Piezo-Signal gemessen, welches sich aus dem angelegten Anregungssignal und einem Zusatzsignal zusammensetzt, das aus der Kopplung des Piezoelements mit dem mechanischen Teilsystem resultiert. An dem gemessenen Piezo-Signal wird eine Schwellwertabfrage durchgeführt, und auf Grundlage des Ergebnisses der Schwellwertabfrage wird beurteilt, ob eine Funktionsstörung des mechanischen Teils und/oder des piezoelektrischen Teils des Gesamtsystems vorliegt.

Der Erfindung liegt die Aufgabe zugrunde, ein Verfahren und eine Vorrichtung zum Überwachen und Beurteilen der Funktionsfähigkeit eines piezoelektrischen Aktors zu schaffen, welches bzw. welche eine möglichst frühzeitige Erkennung eines Fehlers eines piezoelektrischen Aktors ermöglicht.

Zur Lösung der Aufgabe sind ein Verfahren und eine Vorrichtung gemäß den unabhängigen Ansprüchen vorgesehen.

Bei dem erfindungsgemäßen Verfahren zum Überwachen und Beurteilen der Funktion eines piezoelektrischen Aktors wird eine akustische Emission des Aktors mittels eines akustischen Sensors überwacht und die Funktion des Aktors anhand der durch den Sensor ermittelten akustischen Emission und insbesondere durch Vergleich der ermittelten akustischen Emission mit einer bei einwandfreier Funktion des Aktors zu erwartenden akustischen Soll-Emission des Aktors beurteilt.

Eine Abweichung der detektierten akustischen Emission des Aktors von der bei einwandfreier Funktion des Aktors zu erwartenden Soll-Emission gibt einen Hinweis auf einen Defekt des Aktors. Dabei hat sich herausgestellt, dass selbst solche Defekte bereits eine merkliche Modifikation der akustischen Emission bewirken, die nicht oder zumindest noch nicht gleich zu einem endgültigen Versagen des Aktors führen.

Mit dem erfindungsgemäßen Verfahren ist also eine frühzeitige Fehlererkennung möglich. Ein defekter Aktor kann dadurch bereits vor seiner vollständigen Zerstörung stillgelegt und der Defekt und insbesondere seine Ursache eingehend analysiert werden. Alternativ oder zusätzlich kann die zeitliche Entwicklung des Defekts bis hin zu einer vollständigen Zerstörung des Aktors untersucht werden. Eine derartige detaillierte Untersuchung der Entstehung und Entwicklung des Defekts ermöglicht es, zukünftige piezoelektrische Aktoren so zu modifizieren, dass der festgestellte Fehler weitgehend vermieden wird. Im Ergebnis lassen sich dadurch piezoelektrische Aktoren mit einer erhöhten Zuverlässigkeit und Lebensdauer schaffen.

Darüber hinaus lässt sich das Verfahren nicht nur zur Fehleranalyse, sondern auch zur Überwachung eines piezoelektrischen Aktors während seines bestimmungsgemäßen Einsatzes verwenden. Ist der Aktor Bestandteil eines Piezo-Injektors eines Kraftfahrzeugverbrennungsmotors, so kann das Verfahren beispielsweise benutzt werden, um einen Fahrer des Kraftfahrzeugs möglichst frühzeitig vor einem Ausfall des Aktors bzw. des Einspritzventils zu warnen und somit einen rechtzeitigen Austausch zu ermöglichen.

Gemäß einer vorteilhaften Ausbildung des erfindungsgemäßen Verfahrens wird die akustische Emission mittels eines akustischen Sensors ermittelt, der mit dem Aktor in Berührung steht. Dies bedeutet eine kompakte und somit platzsparende Anordnung von Aktor und Sensor, die insbesondere dann von Vorteil ist, wenn der Aktor im Inneren eines Einspritzventils angeordnet ist.

Bei dem Sensor kann es sich z.B. um ein separates Bauteil handeln, welches an einem bereits vormontierten Aktor befestigt und beispielsweise an einer Außenseite des Aktors angebracht wird. Alternativ oder zusätzlich kann der Sensor einen Bestandteil des Aktors selbst und insbesondere einen Bestandteil eines Piezopakets des Aktors umfassen.

Bevorzugt wird die akustische Emission mittels eines piezoelektrischen Beschleunigungssensors ermittelt. Ein derartiger Sensor weist nicht nur eine geringe Baugröße auf, sondern er reagiert auch besonders empfindlich auf Vibrationen des Aktors und somit auf eine akustischen Emission des Aktors. Der Beschleunigungssensor kann z.B. ein dreidimensionaler Beschleunigungsaufnehmer sein, so dass Vibrationen des Aktors in allen drei Raumrichtungen detektierbar sind.

Die Messung der akustischen Emission beruht dabei auf dem piezoelektrischen Effekt, d.h. eine ein akustisches Signal hervorrufende Vibration des Aktors bewirkt eine Verformung eines piezoelektrischen Elements des Sensors, wodurch ein elektrisches Feld in dem piezoelektrischen Element erzeugt wird, welches in Form einer elektrischen Spannung ausgelesen werden kann.

Die durch den Sensor ausgegebene elektrische Spannung kann durch einen Verstärker verstärkt und über ein geeignetes Ausgabemittel, wie beispielsweise einen Lautsprecher oder ein Oszilloskop, akustisch oder optisch dargestellt werden. Gegebenenfalls kann das ermittelte Spannungssignal in einer Auswerteeinheit automatisch ausgewertet werden und eine Abweichung des gemessenen Signals von einem Soll-Signal ermittelt werden.

Vorteilhafterweise wird die akustische Emission mittels einer separaten piezoelektrischen Schicht ermittelt, die an einer Außenseite des Aktors oder eines Piezopakets des Aktors angebracht ist. Eine derartige piezoelektrische Schicht stellt eine besonders einfache Form eines piezoelektrischen Beschleunigungssensors dar und bewirkt keine wesentliche Erhöhung der Baugröße des Piezopakets bzw. des Aktors.

Alternativ oder zusätzlich kann die akustische Emission auch mittels einer piezoelektrischen Schicht ermittelt werden, die Bestandteil des Aktors und insbesondere Bestandteil eines Piezopakets des Aktors ist. In diesem Fall braucht kein separates Bauteil zur Überwachung der akustischen Emission vorgesehen zu werden, sondern es wird der Aktor bzw. das Piezopaket selbst als Sensor verwendet. Dies ermöglicht eine Überwachung der akustischen Emission ohne Erhöhung der Baugröße des Piezopakets bzw. des Aktors.

Bevorzugt wird der akustische Sensor über einen Leitungsstrang ausgelesen, über den der Aktor gesteuert wird. Da in einem Diesel-Einspritzventil eines Common-Rail-Systems Drücke von bis zu 2000 bar herrschen können, erweist es sich als schwierig und möglicherweise gefährlich, zusätzliche elektrische Eingangs- bzw. Ausgangsöffnungen zum Auslesen des Sensors in dem Ventilgehäuse vorzusehen. Dies gilt umso mehr, wenn der Aktor derart in dem Einspritzventil angeordnet ist, dass er von Kraftstoff umströmt wird. Da die Steuerung des Aktors und das Auslesen des Sensors über denselben Leitungsstrang erfolgen, brauchen keine zusätzlichen Eingangs- bzw. Ausgangsöffnungen in dem Ventil vorgesehen zu werden. Das Einspritzventil kann also bei Verwendung eines akustischen Sensors in seiner bestehenden Form weiter verwendet werden.

Gemäß einer weiteren Ausführungsform des erfindungsgemäßen Verfahrens wird aus der Art der ermittelten akustischen Emission und insbesondere aus einer Abweichung der ermittelten akustischen Emission von einer bei einwandfreier Funktion des Aktors zu erwartenden Soll-Emission auf die Art einer Schädigung des Aktors geschlossen. Hierbei wird ausgenutzt, dass bestimmte Defekte eine charakteristische Modifikation der akustischen Emission verursachen.

Bei einer vorbestimmten Form einer Abweichung der ermittelten akustischen Emission von einer bei einwandfreier Funktion des Aktors zu erwartenden Soll-Emission kann ein Warnsignal ausgegeben werden. Dies ermöglicht eine frühzeitige Warnung vor einem drohenden Versagen des piezoelektrischen Aktors.

Dabei kann die vorgegebene Abweichung des detektierten akustischen Signals von dem Soll-Signal so gewählt werden, dass eine Deaktivierung und/oder ein Austausch des defekten piezoelektrischen Aktors möglich ist, bevor dieser vollständig zerstört wird. Dient der Aktor beispielsweise zur Betätigung eines Piezo-Injektors eines Kraftfahrzeugverbrennungsmotors, so kann der Fahrer des Kraftfahrzeugs so rechtzeitig auf den Defekt aufmerksam gemacht werden, dass ein Austausch des piezoelektrischen Aktors möglich ist, bevor die Motorleistung merklich beeinflusst oder der Motor beschädigt wird.

Die erfindungsgemäße Vorrichtung dient der Durchführung des erfindungsgemäßen Verfahrens und ermöglicht somit die Erreichung der voranstehend genannten Vorteile.

Nachfolgend wird die Erfindung rein beispielhaft anhand vorteilhafter Ausführungsformen unter Bezugnahme auf die Zeichnung beschrieben.
Es zeigen:
- Fig. 1: eine schematische Darstellung einer ersten Ausführungsform der erfindungsgemäßen Vorrichtung zur Überwachung und Beurteilung der Funktion eines piezoelektrischen Aktors; und
- Fig. 2: eine schematische Darstellung einer zweiten Ausführungsform der erfindungsgemäßen Vorrichtung zur Überwachung und Beurteilung der Funktion eines piezoelektrischen Aktors.

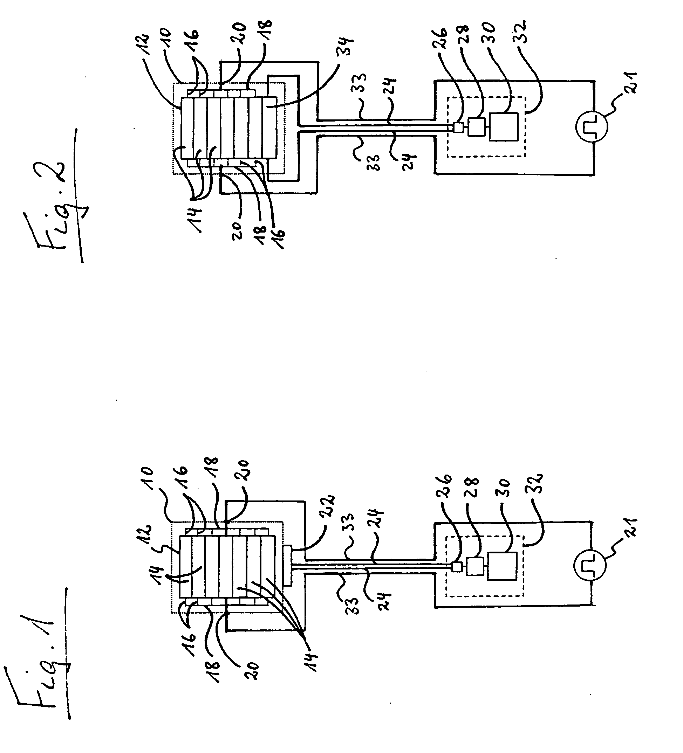

In Fig. 1 ist eine erste Ausführungsform der erfindungsgemäßen Vorrichtung zur Überwachung und Beurteilung der Funktionsfähigkeit eines piezoelektrischen Aktors 10 dargestellt.

Der Aktor 10 umfasst ein Piezopaket 12, welches aus mehreren hundert übereinander gestapelten Keramikschichten 14 gebildet ist, von denen in der Figur lediglich sieben beispielhaft dargestellt sind. Jede Keramikschicht 14 ist über zwei Elektroden 16 mit zwei Sammelelektroden 18 verbunden, die ihrerseits jeweils mit einem externen Anschluss 20 des Aktors 10 verbunden sind.

Über die Anschlüsse 20 ist der Aktor 10 mit einer Stromquelle 21 verbunden, die einen pulsbreitenmodulierten Pulsstrom an den Aktor 10 liefert. Durch einen Strompuls wird der Aktor 10 zunächst entladen und dann wieder definiert aufgeladen. Während der zwischen zwei Pulsen liegenden Zeit wird die aufgebrachte elektrische Ladung in dem Aktor 10 gehalten. In diesem aufgeladenen Zustand ist das Piezopaket 12 ausgedehnt, so dass beispielsweise eine Ventilnadel eines Einspritzventils auf dem zugehörigen Ventilsitz gehalten wird.

Bei einer Verwendung des Aktors 10 in einem piezoelektrischen Einspritzventil eines Kraftfahrzeugverbrennungsmotors kann die Pulsbreite etwa 0,4 ms betragen und dabei 5 % einer Taktzeit ausmachen, so dass sich die Zeit zwischen zwei Strompulsen auf 95 % der Taktzeit und somit auf etwa 0,7 s beläuft.

Zur Ermittlung einer akustischen Emission des Aktors 10 dient ein piezoelektrischer Beschleunigungssensor 22. Bei dem Beschleunigungssensor 22 handelt es sich um ein separates Bauteil, welches bei dem gezeigten Ausführungsbeispiel an einer Außenseite des Aktors 10 befestigt ist. Alternativ kann der Beschleunigungssensor 22 auch direkt an dem Piezopaket 12 angebracht sein.

Mit Hilfe des Beschleunigungssensors 22 lässt sich eine die akustische Emission des Aktors 10 verursachende Vibration des Aktors 10 detektieren. Die Vibration des Aktors 10 bewirkt eine Verformung eines piezoelektrischen Elements des Beschleunigungssensors 22, durch welche ein elektrisches Feld in dem piezoelektrischen Element erzeugt wird.

Das elektrische Feld wird in Form einer elektrischen Spannung über elektrische Leitungen 24 ausgelesen. Die Stärke und der zeitliche Verlauf der ausgelesenen Spannung geben Aufschluss über die zeitliche Entwicklung der Verformung des piezoelektrischen Elements des Beschleunigungssensors 22 und somit über die Amplitude und Frequenz der Vibration des Aktors 10, welche letztlich die Amplitude und Frequenz der akustischen Emission des Aktors 10 bestimmen.

Das aus dem Beschleunigungssensors 22 ausgelesene Spannungssignal wird einem Signalverstärker 26 zugeführt. In einer Vergleichseinheit 28 wird das verstärkte elektrische Signal mit einem bei einwandfreier Funktion des Aktors 10 zu erwartenden Soll-Signal verglichen und eine Abweichung des ermittelten Signals von dem Soll-Signal festgestellt.

Die festgestellte Abweichung des ermittelten Signals von dem Soll-Signal wird in einer Auswerteeinheit 30 analysiert. Bei einer vorgegebenen Form der Abweichung, beispielsweise bei einer Über- bzw. Unterschreitung einer vorgegebenen Frequenz- und/oder Amplitudenschwelle, kann ein entsprechendes Warnsignal ausgegeben werden, um auf eine Beschädigung des Aktors 10 bzw. auf ein drohendes Versagen des Aktors 10 hinzuweisen und somit eine vorzeitige Deaktivierung bzw. einen Austausch des Aktors 10 zu ermöglichen.

Bei dem dargestellten Ausführungsbeispiel sind der Signalverstärker 26, die Vergleichseinheit 28 und die Auswerteeinheit 30 in einer Recheneinheit 32 zusammengefasst. Grundsätzlich ist es aber auch möglich, den Signalverstärker 26, die Vergleichseinheit 28 und die Auswerteeinheit 30 als separate Komponenten vorzusehen.

Zu Labortestzwecken ist es außerdem möglich, auf eine automatische Auswertung des ermittelten akustischen Signals zu verzichten und anstelle der Vergleichseinheit 28 und der Auswerteeinheit 30 ein optisches oder akustisches Ausgabemittel vorzusehen, beispielsweise einen Lautsprecher oder ein Oszilloskop, um eine Auswertung der ermittelten akustischen Emission per Augenschein oder Gehör zu ermöglichen.

Wie in Fig. 1 angedeutet ist, sind die elektrischen Leitungen 24 zum Auslesen des Beschleunigungssensors 22 und elektrische Leitungen 33 zum Ansteuern des Aktors 10 zumindest abschnittsweise zu einem gemeinsamen Kabelstrang zusammengefasst. Dies reduziert den zur Überwachung der akustischen Emission des Aktors 10 erforderlichen apparativen Aufwand. Ist der Aktor 10 beispielsweise zur Betätigung eines Kraftstoff-Einspritzventils vorgesehen, so brauchen in einem Gehäuse des Ventils keine zusätzlichen Öffnungen zum Durchführen der elektrischen Leitungen 24 vorgesehen zu werden. Vielmehr können die zum Auslesen des Beschleunigungssensors 22 vorgesehenen elektrischen Leitungen 24 und die für die Stromversorgung des Aktors 10 vorgesehenen elektrischen Leitungen 33 durch eine gemeinsame Öffnung des Ventilgehäuses aus diesem herausgeführt bzw. in dieses hineingeführt werden.

In Fig. 2 ist eine zweite Ausführungsform der erfindungsgemäßen Vorrichtung zur Überwachung und Beurteilung der Funktionsfähigkeit des piezoelektrischen Aktors 10 dargestellt.

Die zweite Ausführungsform unterscheidet sich von der in Fig. 1 gezeigten ersten Ausführungsform lediglich darin, dass kein separater Beschleunigungssensor 22 an dem Aktor 10 angebracht ist, sondern der akustische Sensor direkt in das Piezopaket 12 integriert ist. Genauer gesagt ist der akustische Sensor bei der zweiten Ausführungsform durch eine Keramikschicht 34 des Piezopakets 12 gebildet. Die akustische Emission des Aktors 10 wird bei dieser Ausführungsform also nicht nur durch das Piezopaket 12 erzeugt, sondern auch durch einen Teil desselben detektiert.

Bei dem in Fig. 2 gezeigten Ausführungsbeispiel ist eine Keramikschicht 34 als Sensor vorgesehen, die sich in einem Endbereich des Piezopakets 12 befindet. Grundsätzlich ist es aber auch möglich, eine in einem mittleren Bereich des Piezopakets 12 angeordnete Keramikschicht 14 als Sensorschicht zu verwenden.

### Bezugszeichenliste

- 10: Aktor
- 12: Piezopaket
- 14: Keramikschicht
- 16: Elektrode
- 18: Sammelelektrode
- 20: Anschluss
- 21: Stromquelle
- 22: Beschleunigungssensor
- 24: Leitung
- 26: Signalverstärker
- 28: Vergleichseinheit
- 30: Auswerteeinheit
- 32: Recheneinheit
- 33: Leitung
- 34: Sensorschicht

## Patentansprüche

1. Verfahren zum Überwachen und Beurteilen der Funktion eines piezoelektrischen Aktors (10), bei dem eine akustische Emission des Aktors (10) mittels eines akustischen Sensors (22; 34) überwacht wird und die Funktion des Aktors (10) anhand der durch den Sensor (22; 34) ermittelten akustischen Emission und durch Vergleich der ermittelten akustischen Emission mit einer bei einwandfreier Funktion des Aktors (10) zu erwartenden akustischen Soll-Emission des Aktors (10) beurteilt wird.

2. Verfahren nach Anspruch 1,
**dadurch gekennzeichnet, dass**
die akustische Emission mittels eines akustischen Sensors (22; 34) ermittelt wird, der mit dem Aktor (10) in Berührung steht.

3. Verfahren nach Anspruch 1 oder 2,
**dadurch gekennzeichnet, dass**
die akustische Emission mittels eines akustischen Sensors (22) ermittelt wird, der an einer Außenseite des Aktors (10) angebracht ist.

4. Verfahren nach einem der vorherigen Ansprüche,
**dadurch gekennzeichnet, dass**
die akustische Emission mittels eines piezoelektrischen Beschleunigungssensors (22; 34), z.B. eines dreidimensionalen Beschleunigungsaufnehmers, ermittelt wird.

5. Verfahren nach einem der vorherigen Ansprüche,
**dadurch gekennzeichnet, dass**
die akustische Emission mittels einer piezoelektrischen Schicht (22) ermittelt wird, die an einer Außenseite des Aktors (10) oder eines Piezopakets (12) des Aktors (10) angebracht ist.

6. Verfahren nach einem der vorherigen Ansprüche,
**dadurch gekennzeichnet, dass**
die akustische Emission mittels einer piezoelektrischen Schicht (34) ermittelt wird, welche Bestandteil des Aktors (10) und insbesondere eines Piezopakets (12) des Aktors (10) ist.

7. Verfahren nach einem der vorherigen Ansprüche,
**dadurch gekennzeichnet, dass**
der akustische Sensor (22; 34) über einen Leitungsstrang ausgelesen wird, über den der Aktor (10) angesteuert wird.

8. Verfahren nach einem der vorherigen Ansprüche,
**dadurch gekennzeichnet, dass**
aus der Art einer ermittelten akustischen Emission und insbesondere aus einer Abweichung der ermittelten akustischen Emission von einer bei einwandfreier Funktion des Aktors (10) zu erwartenden Soll-Emission auf die Art einer Schädigung des Aktors (10) geschlossen wird.

9. Verfahren nach einem der vorherigen Ansprüche,
**dadurch gekennzeichnet, dass**
bei einer vorbestimmten Form einer Abweichung einer ermittelten akustischen Emission von einer bei einwandfreier Funktion des Aktors (10) zu erwartenden Soll-Emision ein Warnsignal ausgegeben wird.

10. Vorrichtung zur Überwachung und Beurteilung der Funktion eines piezoelektrischen Aktors (10) mit einem akustischen Sensor (22; 34) zum Überwachen einer akustischen Emission des Aktors (10) und einer mit dem Sensor (22; 34) verbundenen Auswerteeinheit (30), um die Funktion des Aktors (10) durch Vergleich der durch den Sensor (22; 34) ermittelten akustischen Emission mit einer bei einwandfreier Funktion des Aktors (10) zu erwartenden akustischen Soll-Emission des Aktors (10) zu beurteilen.

11. Vorrichtung nach Anspruch 10,
**dadurch gekennzeichnet, dass**
der Sensor (22; 34) ein piezoelektrischer Beschleunigungssensor ist.

12. Vorrichtung nach Anspruch 10 oder 11,
**dadurch gekennzeichnet, dass**
der Sensor (34) eine piezoelektrische Schicht umfasst, die an einer Außenseite des Aktors (10) oder eines Piezopakets (12) des Aktors (10) angeordnet ist.

13. Vorrichtung nach einem der Ansprüche 10 bis 12,
**dadurch gekennzeichnet, dass**
der Sensor eine piezoelektrische Schicht (34) umfasst, die Bestandteil des Aktors (10) und insbesondere eines Piezopakets (12) des Aktors (10) ist.

14. Vorrichtung nach einem der Ansprüche 10 bis 13,
**dadurch gekennzeichnet, dass**
eine Warneinrichtung vorgesehen ist, um bei einer vorbestimmten Form einer Abweichung der ermittelten akustischen Emission von der Soll-Emission ein Warnsignal auszugeben.

## Claims

1. A method for the monitoring and evaluation of the operation of a piezoelectric actuator (10), wherein an acoustic emission of the actuator (10) is monitored by means of an acoustic sensor (22; 34) and the operation of the actuator (10) is evaluated with reference to the acoustic emission determined by the sensor (22; 34) and by a comparison of the acoustic emission determined with a desired acoustic emission of the actuator (10) to be expected with a problem-free operation of the actuator (10).

2. A method in accordance with claim 1, **characterized in that** the acoustic emission is determined by means of an acoustic sensor (22; 34) which is in contact with the actuator (10).

3. A method in accordance with claim 1 or claim 2, **characterized in that** the acoustic emission is determined by means of an acoustic sensor (22) which is attached to an outer side of the actuator (10).

4. A method in accordance with any one of the preceding claims, **characterized in that** the acoustic emission is determined by means of a piezoelectric acceleration sensor (22; 34), e.g. by means of a three-dimensional acceleration transducer.

5. A method in accordance with any one of the preceding claims, **characterized in that** the acoustic emission is determined by means of a piezoelectric layer (22) which is attached to an outer side of the actuator (10) or of a piezo package (12) of the actuator (10).

6. A method in accordance with any one of the preceding claims, **characterized in that** the acoustic emission is determined by means of a piezoelectric layer (34) which is a component of the actuator (10) and in particular of a piezo package (12) of the actuator (10).

7. A method in accordance with any one of the preceding claims, **characterized in that** the acoustic sensor (22; 34) is read out via a cable section via which the actuator (10) is controlled.

8. A method in accordance with any one of the preceding claims, **characterized in that** the type of damage to the actuator (10) is concluded from the type of acoustic emission determined and in particular from a deviation of the determined acoustic emission from a desired emission to be expected with a problem-free operation of the actuator (10).

9. A method in accordance with any one of the preceding claims, **characterized in that**, with a predetermined form of a deviation of a determined acoustic emission from a desired emission to be expected with a problem-free operation of the actuator (10), a warning signal is output.

10. An apparatus for the monitoring and evaluation of the operation of a piezoelectric actuator (10) comprising an acoustic sensor (22; 34) for the monitoring of an acoustic emission of the actuator (10) and an evaluation unit (30) connected to the sensor (22; 34) to evaluate the operation of the actuator (10) by a comparison of the acoustic emission determined by the sensor (22; 34) with a desired acoustic emission of the actuator (10) to be expected with a problem-free operation of the actuator (10).

11. An apparatus in accordance with claim 10, **characterized in that** the sensor (22; 34) is a piezoelectric acceleration sensor.

12. An apparatus in accordance with claim 10 or 11, **characterized in that** the sensor (34) comprises a piezoelectric layer which is arranged at an outer side of the actuator (10) or of a piezo package (12) of the actuator (10).

13. An apparatus in accordance with any one of the claims 10 to 12, **characterized in that** the sensor comprises a piezoelectric layer (34) which is a component of the actuator (10) and in particular of a piezo package (12) of the actuator (10).

14. An apparatus in accordance with any one of the claims 10 to 13, **characterized in that** a warning device is provided to output a warning signal on a predetermined form of a deviation of the determined acoustic emission from the desired emission.

## Revendications

1. Procédé pour surveiller et apprécier le fonctionnement d'un actionneur piézo-électrique (10) dans lequel une émission acoustique de l'actionneur (10) est surveillée au moyen d'un capteur acoustique (22 ; 34) et le fonctionnement de l'actionneur (10) est apprécié à l'aide de l'émission acoustique déterminée par le capteur (22 ; 34) et par comparaison de l'émission acoustique déterminée avec une émission acoustique de consigne de l'actionneur (10) à laquelle il faut s'attendre dans le cas d'un fonctionnement parfait de l'actionneur (10).

2. Procédé selon la revendication 1,
**caractérisé en ce que**
l'émission acoustique est déterminée au moyen d'un capteur acoustique (22 ; 34) qui est en contact avec l'actionneur (10).

3. Procédé selon la revendication 1 ou 2,
**caractérisé en ce que**
l'émission acoustique est déterminée au moyen d'un capteur acoustique (22) qui est placé sur une face extérieure de l'actionneur (10).

4. Procédé selon l'une des revendications précédentes,
**caractérisé en ce que**
l'émission acoustique est déterminée au moyen d'un capteur d'accélération piézo-électrique (22 ; 34), par exemple d'un capteur d'accélération tridimensionnel.

5. Procédé selon l'une des revendications précédentes,
**caractérisé en ce que**
l'émission acoustique est déterminée au moyen d'une couche piézo-électrique (22) qui est placée sur une face extérieure de l'actionneur (10) ou d'un paquet piézo-électrique (12) de l'actionneur (10).

6. Procédé selon l'une des revendications précédentes,
**caractérisé en ce que**
l'émission acoustique est déterminée au moyen d'une couche piézo-électrique (34) qui fait partie intégrante de l'actionneur (10) et en particulier d'un paquet piézo-électrique (12) de l'actionneur (10).

7. Procédé selon l'une des revendications précédentes,
**caractérisé en ce que**
le capteur acoustique (22 ; 34) est sélectionné par un faisceau de lignes par lequel l'actionneur (10) est commandé.

8. Procédé selon l'une des revendications précédentes,
**caractérisé en ce que**
à partir du type d'une émission acoustique déterminée et en particulier d'un écart de l'émission acoustique déterminée par rapport à une émission de consigne à laquelle il faut s'attendre en cas de fonctionnement parfait de l'actionneur (10), il est conclu au type d'endommagement de l'actionneur (10).

9. Procédé selon l'une des revendications précédentes,
**caractérisé en ce que**
dans le cas d'une forme prédéterminée d'un écart d'une émission acoustique déterminée par rapport à une émission de consigne à laquelle il faut s'attendre en cas de fonctionnement parfait de l'actionneur (10), un signal d'avertissement est délivré.

10. Dispositif de surveillance et d'appréciation du fonctionnement d'un actionneur piézo-électrique (10) comportant un capteur acoustique (22 ; 34) pour surveiller une émission acoustique de l'actionneur (10) ainsi qu'une unité d'évaluation (30) reliée au capteur (22 ; 34) afin d'apprécier le fonctionnement de l'actionneur (10) par comparaison de l'émission acoustique déterminée par le capteur (22 ; 34) avec une émission acoustique de consigne de l'actionneur (10) à laquelle il faut s'attendre en cas de fonctionnement parfait de l'actionneur (10).

11. Dispositif selon la revendication 10,
**caractérisé en ce que**
le capteur (22 ; 34) est un capteur d'accélération piézo-électrique.

12. Dispositif selon la revendication 10 ou 11,
**caractérisé en ce que**
le capteur (34) comprend une couche piézo-électrique qui est disposée sur une face extérieure de l'actionneur (10) ou d'un paquet piézo-électrique (12) de l'actionneur (10).

13. Dispositif selon l'une des revendications 10 à 12,
**caractérisé en ce que**
le capteur comprend une couche piézo-électrique (34) qui fait partie intégrante de l'actionneur (10) et en particulier d'un paquet piézo-électrique (12) de l'actionneur (10).

14. Dispositif selon l'une des revendications 10 à 13,
**caractérisé en ce que**
il est prévu un dispositif d'avertissement pour délivrer un signal d'avertissement dans le cas d'une forme prédéterminée d'un écart de l'émission acoustique déterminée par rapport à l'émission de consigne.
